**Europäisches Patentamt**

**European Patent Office**

**Office européen des brevets**

(19)

(11) Publication number: **0 216 414**
**A1**

(12) # EUROPEAN PATENT APPLICATION

(21) Application number: **86201501.3**

(22) Date of filing: **01.09.86**

(51) Int. Cl.⁴: **G 01 R 13/06**

(30) Priority: **04.09.85 NL 8502432**

(43) Date of publication of application:
**01.04.87 Bulletin 87/14**

(84) Designated Contracting States:
**AT BE CH DE FR GB IT LI LU NL SE**

(71) Applicant: **Bakker Electronics Dongen B.V.**
**Minister Aalberselaan 10**
**NL-5103 BA Dongen(NL)**

(72) Inventor: **Bakker, Johannes Hermanus**
**Beneluxlaan 20**
**NL-5101 ZD Dongen(NL)**

(74) Representative: **Konings, Lucien Marie Cornelis**
**Joseph et al,**
**OCTROOIBUREAU ARNOLD & SIEDSMA Sweelinckplein**
**1**
**NL-2517 GK Den Haag(NL)**

(54) Wave form analyser, especially transient recorder.

(57) Wave form analyser, especially transient recorder characterized by a positioning member (14) or "mouse", provided with an operating member (13). The functions of the wave form analyser can be activated by moving a pointer (7) across a display screen (6) and then operating the operating member (13).

FIG 1

EP 0 216 414 A1

# Wave form analyser, especially transient recorder  0216414

The invention relates to a wave form analyser, especially transient recorder in accordance with the preamble of claim 1.

Such a transient recorder is known from the article "Advanced waveform recorders do more than capture transients" from EDN, volume 23, no.16, September 1978, for example for recording transient phenomena in the field or in the laboratory which occur in the electricity mains or which emanate from transducers which generate signals from collision tests with automobiles. In such a transient recorder, setting and control is mostly carried out using a keyboard or a plurality of circuit means, which in practical use is not convenient.

The purpose of the invention is to provide an easily operated transient recorder.

This aim is achieved by applying the characteristic as claimed in claim 1 in the transient recorder.

Using the positioning member and the control program it is possible to adjust and control the transient recorder very efficiently and quickly, as all the routines of the control program can be reached rapidly. In the known transient recorder it has no longer been found possible to maintain the required flexibility with regard to reproducing a transient phenomenon on a display screen as well as the possibilities with regard to setting means, control means and where necessary arithmetic means for processing derived signals, without this leading to a very inconveniently arranged and little manageable transient recorder. All graphic functions, such as the positioning of the coordinate axes of a transient phenomenon to be recorded, as well as its time/amplitude setting, have thus to be adjusted using the control means. The amplifiers and the so-called "triggering", that is the determining at which signal value the transient recorder becomes operative, of each module must be controlled and adjusted via the control means. Furthermore, the arrangement of the screen must be changed depending on whether one or more recording signals are being shown, the control, the so-called menu, must be displayed on the screen and it must be possible to write figures and letters or the relevant graphics. In the transient recorder according to the invention it is easy to run through all these control possibilities via a control program, because use can be made of the different possibilities easily with the aid of the positioning member. All the routines of the control program are directly accessible by means of activating the operating member; the usual tree structure, whereby multiple choice questions have to be answered each time, can be dispensed with, as well as the allied QWERTY keyboard. Finally, it is desirable to include arithmetic routines in the control program, such as an FFT routine or a correlation for example, which can be controlled via the control means and the results of which can be displayed simply on the display screen.

It is also possible as a result for all the components of the transient recorder to be accommodated in one cabinet so that a transient recorder results that is easy to handle.

Further advantages, features and details will be described in the following, with reference to a drawing, in which:

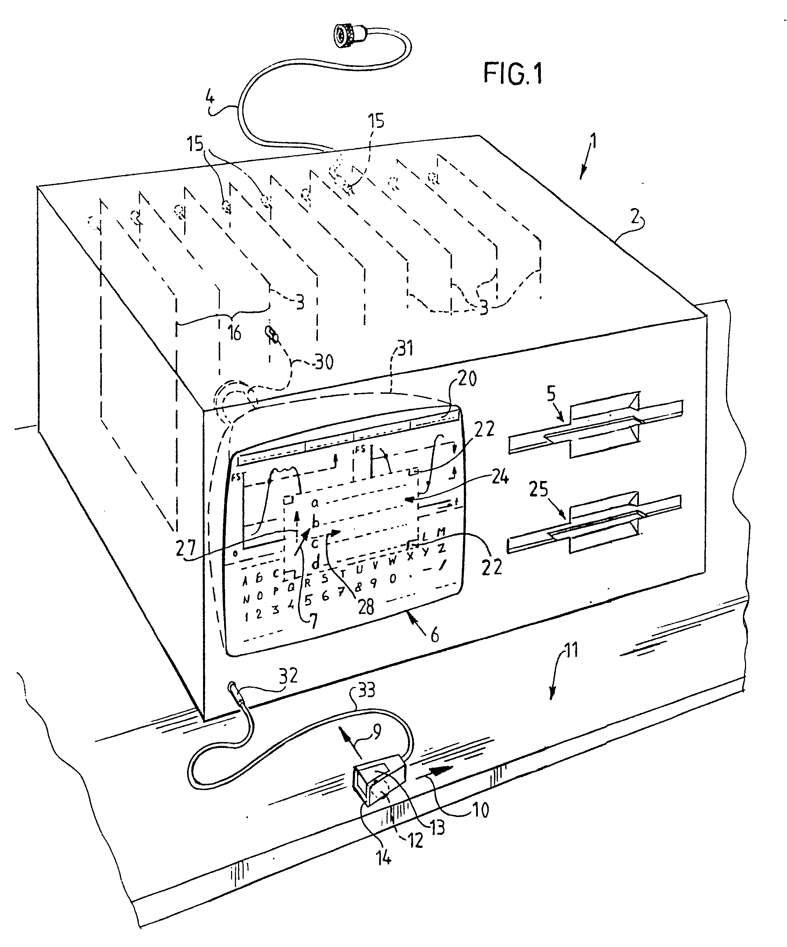

fig. 1 shows a perspective, partly schematic view of a transient recorder according to the invention,

fig. 2 shows typical successive images on the screen from fig. 1, and

fig. 3 shows a screen part provided with a calculator program.

An embodiment of a transient recorder 1 according to the invention consists of a cabinet 2 in which recording modules 3 are accommodated, each of which can be connected to a transient phenomenon via a lead 4 and an input 15. The modules are provided in the usual manner with an analog-digital converter and a memory for storing digital signals which are formed on cards provided with electronic components in the usual manner. At the rear of cabinet 2 the recording modules 3 are connected to the control means 16 (not shown), which likewise consist of cards provided with electronic components, this embodiment having three such cards. These three cards are mutually interconnected at the rear as well as being linked via a lead 30 to the control of a picture tube 31.

In addition transient recorder 1 is provided with read/write devices 5 and 25 arranged in cabinet 2, whereby the one read/write device serves for writing onto a data information disc, so that the measured values of the transient phenomenon can be written onto it, while the other read/write device 25 can contain an information disc for holding the control program which must be stored in the control means 16. These functions of the read/write devices are of course interchangeable.

On the front of cabinet 2 the control means 16 and the screen 6 are now linked via a connection 32 and a lead 33 in a manner not shown to a positioning member 14 provided with a rolling member 12 and an operating member 13, which positioning member can be moved manually by the operator over a surface 11, for example a table top.

When rolling member 12 is rolled in direction 9, or 10 or a direction that is a combination of these two directions, a pointing element 7, for example an arrow, is moved over the display screen 6 in corresponding directions 27, 28 or a direction that is a combination of these two, whereby the screen 6 is coupled to the control means 16 such that a movement of pointing element 7 brings about a change in a starting point in the control program and whereby the control program becomes operative from that starting point when the operating member 13 is activated. The positioning member can be a so-called mouse of the known type.

From the figure can be seen that on display screen 6 a window 21 can be placed over an existing display of figures and letters and for example two particular recordings, within which window the pointing element 7 can be moved using the positioning member, so that when the operating member 13 is activated a new command from the control program is performed, following which the window 21 can be once again removed from the original display, for example via an auxiliary field 22. Using auxiliary fields 22 and control fields 20, which are located at the top of the display screen 6, all the functions mentioned in the description preamble can be performed in a rapid and efficient manner, resulting in an extremely user-friendly transient recorder.

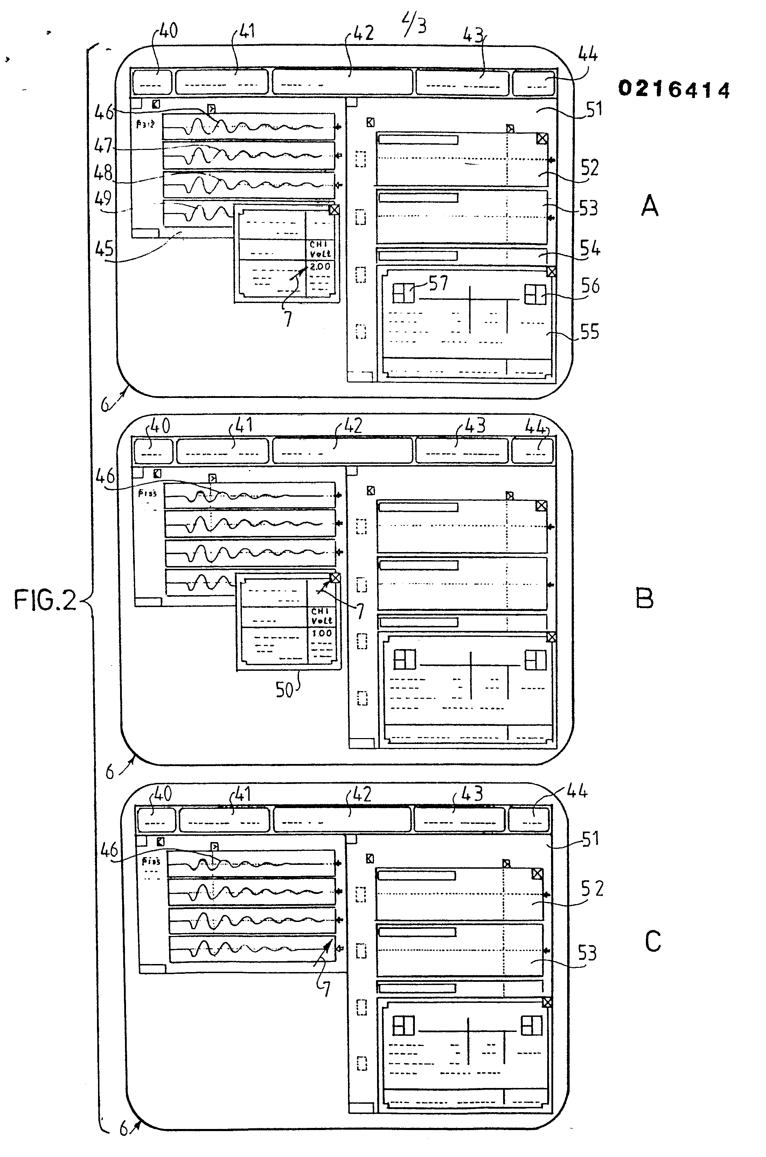

Indicated by A, B, C on the display screen in fig. 2 are three typical recordings. The control fields 40, 41, 42, 43 and 44 contain for example respectively HELP, FUNCTION LIST, PAGE NUMBER, SYSTEM DIAGRAM and ACTUAL TIME. In a screen portion 45 four transient signals 46, 47, 48 and 49 are displayed one below the other, whereby a window 50 is placed partially over transient signal 49 for the setting of determined parameters of the transient signals. In a right-hand screen portion 51 provision can be made for example for possibilities for enlarging the signals in screen portion 45, this in the frames 52, 53 and 54, which however, as can be seen, are not operative. In a window 55 which overlaps a part of the right-hand screen portion 51 can be seen in square 56 how the display screen is laid out at this moment, while using square 57 is indicated in a manner not shown where the pointing element 7 is located at this moment. All text in the figures is indicated in the figures 2A, 2B and 2C by dashes, as this makes the figures clearer and the text is not of essential importance.

In fig. 2A the pointing element 7 is located for example at the number 2.00 which in this case indicates the vertical scale along the axis of transient signal 46. Using the operating member such a value can be changed, as can be seen in fig. 2B, in which the reproduction of the transient signal 46 has also been changed. After bringing pointing element 7 to an auxiliary field 58 using the rolling member and after activating the operating member, the window 50 disappears from the display screen, while pointing element 7 remains in the same position (fig. 2C). After removal of this window 50 the control program of the transient recorder is immediately situated in another routine, so that the operating member will have immediately acquired an entirely different function.

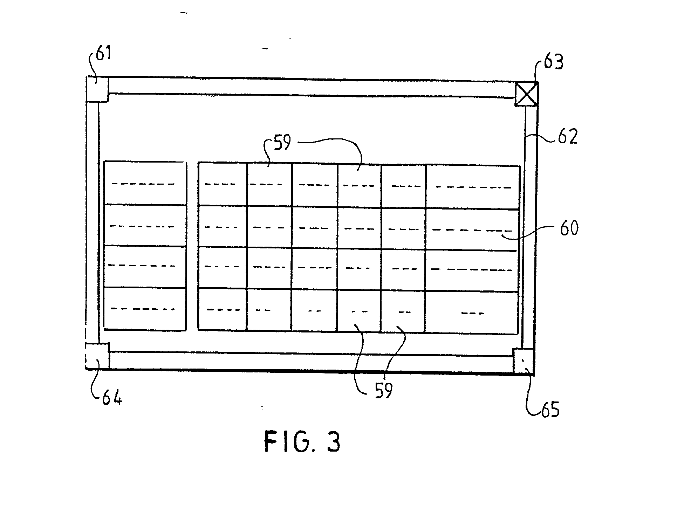

Via the control filed 43 from fig. 2 and an intermediate window (not shown) access can be acquired to a so-called DATA calculator window (fig. 3), with which all arithmetic functions necessary for signal processing can be reached by bringing the pointing element to the squares 59. Thus are made possible, for example, addition, subtraction, multiplication, differentiation, integration, "smoothing", FFT, exponential and logarithmic values, the determining of maxima and minima of different signals, as well as the introduction of numerical values via a square 60. There can also be provided a second DATA window, for instance for providing a so-called LEARN MODE, in which certain fixed pre-used values of some parameters as well as certain standard procedures in working with the analyser are to be stored. When the pointing element is taken to square 60 a new window will appear with numeric characters, from which a choice can be made.

Using the auxiliary window 61, a window can be placed over the relevant DATA calculator window; using auxiliary window 63 this window can be removed after activation of te operating member, using auxiliary window 64 the window 62 can be moved over the screen, while using the auxiliary window 65 the size of the window 62 can be changed.

It will be apparent that using the above described features of the transient recorder according to the invention an alphanumeric keyboard will no longer be necessary.

Further details of the transient recorder according to the invention can be learned from the co-pending patent application based on NL 8502433.

= 5 -

CLAIMS

1. Wave form analyser, especially transient recorder (1) for digitally recording signals emanating from a transient phenomenon of relatively short duration, comprising at least one recording module (3) provided with an input (15) which module is connectable to said transient phenomena, and is provided with an analog-digital converter for storing the digital signals, at least one read/write device (5) for reading and writing to an information disc from said transient recorder, a display screen (6) for displaying said transient phenomenon, at least one stop or trigger member for stopping or triggering the recording, and setting means that can be controlled using control means (16) for setting different parameters for digital recording of and displaying on said display screen (6) of said transient phenomenon, characterized by a positioning member (14) which is coupled with a pointing element (7) movable over the display screen (6) in two directions, is provided with a rolling member (12) rollable over a surface (11) in two directions and an operating member (13), and by a control program stored from said read/write device (5) in said control means (16), whereby a relative movement of said rolling member (12) subjects said pointing element (7) to a corresponding movement in two directions (27, 28) over said display screen (6), whereby said display screen (6) is coupled to said control means (16) such that a movement of said pointing element (7) brings about a change of the starting point in said control program and whereby at activation of said operating member (13) said control program is operative from that starting point.

2. Wave form analyser, especially transient recorder (1) as claimed in claim 1, characterized by a cabinet (2) comprising the or each recording module (3), the or each stop member, the control means (16), the display screen (6) and the or each read/write device (5).

-1-

3. Wave form analyser, especially transient recorder (1) as claimed in claim 1, characterized by two read/write devices (5, 25), whereby one read/write device (5) is arranged to hold a data information disc, while the other read/write device (25) is arranged to hold the information disc for the control program.

4. Wave form analyser, especially transient recorder (1) as claimed in claim 1, 2 or 3, characterized in that during operation the display screen (6) comprises at least one control field (20), using which at least one window (21) can be placed over the original image of said display screen (6).

5. Wave form analyser, especially transient recorder (1) as claimed in claim 3, characterized in that various windows can be placed over one another.

6. Wave form analyser, especially transient recorder (1) as claimed in claim 4 or 5, characterized in that the or each window (21) is provided with at least one auxiliary field (22) using which window functions can be operated.

7. Wave form analyser, especially transient recorder (1) as claimed in any of the foregoing claims, characterized in that the control means (16) are arranged such that four channels for transient phenomena (46, 47, 48, 49) can be displayed on the display screen (6).

8. Wave form analyser, especially transient recorder (1) as claimed in any of the foregoing claims, characterized in that the control means (16) are provided with a calculator program which can be displayed on the display screen (6) and which becomes operative after activation using the operating member (13), in order to perform arithmetic routines on the transient signals.

9. Wave form analyser, especially transient recorder (1) as claimed in any of the foregoing claims, characterized in that using the control means (16) the display screen (6) can be divided into screen portions (45, 51).

* * * *

-2-

FIG.1

FIG.2

0216414

0216414

FIG. 3

13021. 3

# 0216414

## EUROPEAN SEARCH REPORT

Application number

EP 86 20 1501

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int Cl.4) |
| A | PROCEEDINGS OF THE IEEE, vol. 72, no. 3, March 1984, pages 331-341, IEEE, New York, US; B. DANIELS: "The architecture of the Lisa personal computer" * Page 332, paragraph: "The Lisa hardware"; figure 1; page 336, paragraph: "The Lisa user interface"; page 337, figures 3,4 * | 1-10 | G 01 R 13/06 |
| A | EDN, vol. 23, no.16, 5th September 1978, pages 103-110, Denver, US; D. DEDINAS: "Advanced waveform recorders do more than capture transients" * Page 103, figure 1, paragraph: "Signals are digitally stored"; page 105, figure 2, right-hand column, two last paragraphs; page 110, left-hand column, paragraph 1 * | 1 | |
| A | EP-A-0 130 428 (SIEMENS AG) | | |
| A | MESSEN + PRÜFEN/AUTOMATIK, no. 4, April 1976, pages 180,182-186,200, Bed Wörishofen, DE; A. HEDERER et al.: "Programmiertes Messen zur Selektierung von Messdaten" | | |

TECHNICAL FIELDS
SEARCHED (Int Cl.4)

G 01 R
G 06 F

The present search report has been drawn up for all claims

| Place of search | Date of completion of the search | Examiner |
|---|---|---|
| THE HAGUE | | KUSCHBERT E. |

EPO Form 1503 03 82